# EUROPÄISCHE PATENTANMELDUNG

(11) **EP 1 617 474 A1**
(43) Veröffentlichungstag der Anmeldung: **18.01.2006**
(21) Anmeldenummer: 04016534.2
(22) Anmeldetag: 14.07.2004
(51) Int. Cl.: H01L 25/065

(54) **Speichermodul und Verfahren zum Herstellen eines Speichermoduls**

(71) Anmelder: Swissbit Germany GmbH, 12681 Berlin (DE)
(72) Erfinder: Prietzsch, Dieter, 12559 Berlin (DE)
(74) Vertreter: Hepp, Dieter

(57) **Zusammenfassung**

Speichermodul mit mehreren, vorzugsweise gleich grossen Speicherchips (1,1'), die auf einem Substrat (2) angeordnet sind. Mindestens zwei Chips (1,1') sind so übereinander gestapelt, dass die Rückseite des oberen Chips (1') gegen die Vorderseite des unteren Chips (1) gerichtet ist und übereinander liegende Chips (1,1') durch eine Isolierschicht (4,5,6) getrennt sind. Zentral an den Chips sind Bondpads (8) angebracht, von denen in etwa parallelen Reihen Bonddrähte (3,3') ausgehen. Die Isolierschicht (4,5,6) weist wenigstens einen festen Isolierkörper (4) und wenigstens einen flüssig einbringbaren, härtenden Werkstoff (5,6) auf. Der Isolierkörper (4) liegt auf den Bonddrähten (3,3') auf.

## Beschreibung

Die Erfindung bezieht sich auf ein Speichermodul und ein Verfahren zum Herstellen eines Speichermoduls gemäss den unabhängigen Patentansprüchen.

Im Stand der Technik sind verschiedene Verfahren zum Stapeln von Chips an einer Leiterplatte zur Herstellung von Speichermodulen bekannt. Ein Beispiel für ein Verfahren und ein also hergestelltes Produkt findet sich in EP 1 278 243. Im Verfahren nach dieser Veröffentlichung werden Nacktchips an die Leiterplatte geklebt und über periphere Bondpads mit der Leiterplatte verbunden. Über zentral auf jeden Chip gelegte Abstandhalter kann eine zweite Lage von Chips über die erste Lage geklebt und erneut peripher gebonded werden. Es lassen sich beliebig viele Schichten übereinander stapeln, weil die Rückseiten der oberen Chips gegen die Vorderseiten der unteren Chips gerichtet sind. Ein ähnliches Verfahren ist zum Beispiel auch aus US 6,005,778 bekannt.

Solche Verfahren haben den Nachteil, dass nur Chips mit peripher angeordneten Bondpads derart gestapelt werden können. Bei zentral angeordneten Bondpads wird das Stapeln der Chips bedeutend schwieriger, weil die Rückseiten der oberen Chips nicht mit den darunter liegenden Bonddrähten in Berührung kommen dürfen.

Aus US 6,531,784 ist ein Speichermodul bekannt, bei dem Chips mit zentralen Bondpads übereinander gestapelt sind. Dazu werden die Bonddrähte über am Rand der Chips angebrachte Isolierstreifen auf die Leiterplatte geführt. Die Isolierstreifen weisen Querrillen auf, durch welche die Bonddrähte einzeln geführt sind, so dass sie sich gegenseitig nicht berühren und in den Isolierstreifen eingelassen sind. Somit berühren sie auch die Rückseite des darüber liegenden Chips nicht. Abschliessend werden die gestapelten Chips in einen Kunststoff eingebettet, der die Anordnung vor äusseren Einflüssen schützt.

Diese Anordnung vereint die Vorteile der zentralen Bondpads mit den Vorteilen der Rück-zu-Vorderseiten-Stapelung der Chips. Die Herstellung ist aber aufwendig. Ausserdem ist die Stabilität des Speichermoduls stark von den Eigenschaften des Kunststoffs abhängig, in den die Chips eingebettet sind. Durch Lufteinschlüsse im Kunststoff werden die Stabilität und die thermischen Eigenschaften des Speichermoduls negativ beeinflusst und somit die Lebensdauer der Module verkürzt.

Aufgabe der vorliegenden Erfindung ist, eine alternative Möglichkeit der Rück-zu-Vorderseiten-Stapelung von Speicherchips bereitzustellen, wobei Chips mit zentralen Bondpads verwendet werden. Weiter ist es Aufgabe der Erfindung, die Lebensdauer und Stabilität des Speichermoduls zu erhöhen.

Diese Aufgaben werden mit einem Speichermodul und einem Verfahren zur Herstellung desselben gemäss den unabhängigen Patentansprüchen gelöst.

Das erfindungsgemässe Speichermodul umfasst mehrere, vorzugsweise gleich grosse Speicherchips, die auf einem Substrat angeordnet sind. Mindestens zwei dieser Chips sind so übereinander gestapelt, dass die Rückseite des oberen Chips gegen die Vorderseite des unteren Chips gerichtet ist und übereinander liegende Chips durch eine Isolierschicht getrennt sind. Die Bondpads sind zentral an den Chips angebracht. Von den Bondpads gehen in etwa parallelen Reihen Bonddrähte aus.

Die Isolierschicht umfasst wenigstens einen festen Isolierkörper und wenigstens einen flüssig einbringbaren, härtenden Werkstoff.

Allgemein werden alle trocknenden oder polymerisierenden Kunststoffe als flüssig einbringbare, härtende Werkstoffe betrachtet. Bevorzugt sind hier polymerisierende Kunststoffe, z.B. Zweikomponenten-Klebstoffe, oder heisshärtende oder feuchtigkeitsreaktive Klebstoffe, weil diese einen sehr geringen Schwund beim Härten aufweisen und wärmebeständig sind.

Der Isolierkörper liegt auf den Bonddrähten auf, womit gemeint ist, dass die Bonddrähte zwischen dem Isolierkörper und dem darunter liegenden Chip geführt werden. Wenn sich der härtende Werkstoff ebenfalls zumindest teilweise unter dem Isolierkörper befindet, ist dies kein Widerspruch dazu, dass der Isolierkörper auf den Bonddrähten aufliegt.

Der Einsatz von Chips mit zentral angeordneten Bondpads ist vorteilhaft, weil dies zu einer wesentlich gleichmässigeren Spannungsverteilung in jedem Chip und in der Gesamtanordnung der Chips führt.

Gemäss einer ersten Ausführungsform können die Bonddrähte in einem Winkel von der Oberfläche des Chips abstehend angeordnet sein, so dass sie im Abstand vom Rand des Chips je einen Bogen aufweisen und in die Richtung zum Chip-Rand hin verlaufen. Der Isolierkörper liegt auf den Bögen der beiden Reihen von Bonddrähten auf.

Durch diese Anordnung sind die Bonddrähte sowohl von der Vorderseite des unteren Chips als auch von der Rückseite des oberen Chips getrennt bzw. isoliert. Der Bonddraht berührt den Chip nur auf dem Bondpad selbst. Der Winkel zwischen den Bonddrähten und dem Chip beträgt vorzugsweise weniger als 5°. Der Betrag des gewählten Winkels hängt von der angestrebten Höhe der Bögen der Bonddrähte ab. Die Bogenhöhe beträgt vorzugsweise 100 bis 200 µm, damit die gesamte Schichtdicke (aus dem Chip und der Isolierschicht bestehend) 500 µm, vorzugsweise 300 µm, nicht übersteigt.

In einer zweiten Ausführungsform können die Bonddrähte im einem ersten Abschnitt etwa parallel zur Oberfläche des Chips verlaufend angeordnet sein und im Abstand vom Rand der Chips je einen von der Chip-Oberfläche abstehenden Bogen aufweisen. In diesem Fall liegt der Isolierkörper auf den parallel zur Oberfläche des Chips verlaufenden Abschnitten der beiden Reihen von Bonddrähten und ist zwischen den Bögen angeordnet.

Bei beiden Ausführungsformen ist es von Vorteil, wenn der Wärmeausdehnungskoeffizient der Isolierschicht nicht mehr als 10% von jenem des Chips abweicht. Dadurch werden Spannungen im Speichermodul reduziert. Dazu sind Isolierkörper geeignet, die wenigstens teilweise aus einem Glas oder aus einer anderen isolierenden Siliziumverbindung bestehen. Andere Materialien mit ähnlichen Eigenschaften sollen aber nicht ausgeschlossen werden.

Zur Stabilisierung ist der Isolierkörper vorzugsweise auf beiden Seiten mit einem aushärtenden Werkstoff mit den benachbarten Chips verbunden ist. Dieser Werkstoff ist vorzugsweise ein Polymer-Werkstoff, z.B. ein Epoxid-Harz. Als aushärtende Polymer-Werkstoffe werden Werkstoffe angesehen, deren Klebewirkung hauptsächlich auf der Polymerisierung oder Vernetzung der Komponenten des Klebstoffs beruht.

Für die Stabilität und erhöhte Lebensdauer des Speichermoduls ist ausserdem von Vorteil, wenn in der Isolierschicht keine Lufteinschlüsse eingeschlossen sind. Dadurch werden Spannungen und Schwachstellen reduziert.

Damit unter Wärmeeinwirkung keine grosse Belastung des Speichermoduls stattfindet ist es ausserdem vorteilhaft, wenn der Werkstoff isolierende Partikel, d.h. Füllstoffe, aufweist, deren Wärmeausdehnungskoeffizient sich um weniger als 10% von jenem der Chips unterscheidet. Diese isolierenden Füllstoffpartikel können zum Beispiel aus Aluminiumoxid, Glas oder ähnlichen Materialien bestehen. Andere geeignete Materialien sind aber auch denkbar.

Es können mehrere, insbesondere zwei unterschiedliche Werkstoffe verwendet werden. Besonders geeignet ist der Isolierkörper mit einem ersten Werkstoff mit dem darunterliegenden Chip partiell verbunden und der freibleibende Spalt zwischen der Chip-Oberfläche und dem Isolierkörper mit einem zweiten Werkstoff gefüllt. Die Kriechfähigkeit des zweiten Werkstoffs ist höher als jene des ersten Werkstoffs, was sich z.B. über die Grösse der Füllstoff-Teilchen und über die Eigenschaften des Werkstoffs regeln lässt. Bei kleineren Füllstoff-Teilchen ist die Kriechfähigkeit des Werkstoffs grösser. Ausserdem ist die Kriechfähigkeit grösser, wenn die Viskosität und das Schubmodul des Werkstoffs kleiner sind. Lufteinschlüsse in der Isolierschicht lassen sich verhindern, indem der zweite, kriechfähigere Werkstoff die Leerräume zwischen den beiden Chips aufgrund von Kapillarkräften ausfüllt.

Im zweiten Ausführungsbeispiel ist die Oberseite des Isolierkörpers in einem grösseren Abstand von der Oberfläche des darunter angeordneten Chips angeordnet als die Bögen der Bonddrähte. Das bedeutet, dass die Dicke der Isolierschicht grösser ist als die Bogenhöhe der Bonddrähte. Dadurch wird sichergestellt, dass die Bonddrähte nicht die Rückseite des darüberliegendes Chips berühren. Am einfachsten lässt sich das Realisieren, indem die Dicke des Isolierkörpers angepasst wird.

Geeignet sind Werkstoffe, die Epoxid-Harz enthalten. Besonders vorteilhaft sind hierbei heisshärtende Epoxid-Klebstoffe. Diese lassen sich unter Wärmeeinwirkung sehr gezielt zur Härtung bringen.

Weiter ist es vorteilhaft, wenn der Werkstoff thixotrope Eigenschaften aufweist. Dadurch kann das Einbringen des Werkstoffs besser kontrolliert werden, da unerwünschtes Fliessverhalten des Werkstoffs reduziert ist. Thixotrop bedeutet, dass sich die Viskosität des noch flüssigen Werkstoffs unter Druck- oder Krafteinwirkung ändert, insbesondere, dass die Viskosität unter Druck- oder Krafteinwirkung abnimmt. Thixotropie ist eine reversible Materialeigenschaft, sobald der Druck bzw. die Kraft auf den Werkstoff nachlässt, steigt die Viskosität wieder an.

Der Hauptvorteil eines thixotropen Werkstoffs ist, dass der Werkstoff vor dem Härten sehr gezielt auf dem Chip verteilt werden kann. So zerfliesst der Werkstoff z.B. nicht ohne äussere Einflüsse und kann tropfenförmig auf den Chip gebracht werden ohne zu verrinnen. Wird z.B. der Isolierkörper auf den thixotropen Werkstoff auf dem Chip aufgelegt, fliesst der Werkstoff durch entstehende Kapillarkräfte, unter dem Gewichtsdruck des Isolierkörpers oder durch zusätzliche Krafteinwirkung, z.B. das Aneinanderpressen des Isolierkörpers und des Chips. Durch gleichzeitiges zuführen von Wärme wird dieses Verhalten verstärkt.

Dadurch, dass der Werkstoff fliesst verteilt er sich besser zwischen dem Chip und dem Isolierkörper. Lufteinschlüsse und andere Unregelmässigkeiten werden so reduziert. Der Isolierkörper senkt sich bis auf die Gipfel der Bonddrähte ab. Die Steifigkeit der Bonddrähte lassen ein weiteres Absinken nicht zu. Eine Deformation der Bonddrähte durch die Kapillarkräfte tritt nicht auf. Es bildet sich also eine Gleichgewichtslage, der Werkstoff wird an weiterem fliessen gehindert. Wenn die Dosierung des Werkstoffs geeignet gewählt wird, quillt er nicht zwischen dem Chip und dem Isolierkörper hervor. Somit wird verhindert, dass der Werkstoff weiter ausfliesst als erwünscht. Also kann die Verteilung des Werkstoffs und der Abstand zwischen dem Chip und dem Isolierkörper sehr genau kontrolliert werden.

Für die Schaltung der einzelnen Chips ist es vorteilhaft, wenn übereinander liegende Chips unterschiedlichen Speicherabschnitten oder Speicherbänken zugeordnet sind. Die Gesamterwärmung des Speichermoduls ist dadurch besser verteilt, und die Wärme kann besser abfliessen, weil vermieden wird, dass unterschiedliche Bänke zur gleichen Zeit aktiv sind. Das Zuordnen zu den Bänken erfolgt über die Verdrahtung.

Besonders effizient ist das Speichermodul, wenn das Substrat ein Speicher-Board ist und die Bonddrähte an zwei gegenüberliegenden Seiten des Chips mit einem Board verbunden sind. Dadurch ist die Anordnung äusserst platzsparend und die Nutzung der Grundfläche ist erhöht.

Ebenfalls vorteilhaft sind die Chips auf beiden Seiten eines flachen Substrats angeordnet. Im Falle eines Speicher-Boards kann der Platz auf dem Board somit besonders gut genutzt werden. Bei immer höheren Anforderungen an Grösse und Speicherkapazität von Speichermodulen ist dies ein grosser Gewinn.

Das Verfahren zum Herstellen eines Speichermoduls aus wenigstens zwei übereinander gestapelten Chips auf einem Substrat unter Verwendung von Chips mit Bonddrähten, die in etwa parallelen Reihen am Mittelabschnitt der Oberfläche des Chips angeordnet sind, umfasst die folgenden Schritte:
a) Verbinden eines ersten Chips mit einem Substrat, insbesondere Kleben des Chips auf das Substrat, und Herstellen einer elektrischen Verbindung zwischen den Bondpads des Chips und Leiterfeldern des Substrats mit den Bonddrähten;
b) Auftragen eines fliessfähigen, vorzugsweise thixotropen aushärtenden Werkstoffs an mindestens einen Punkt auf dem Chip;
c) Aufbringen eines Isolierkörpers auf den Werkstoff zum wenigstens teilweisen Abdecken der Bonddrähte;
d) wenigstens teilweises Härten des Werkstoffs;
e) Aufbringen eines weiteren Chips auf dem Isolierkörper, insbesondere Kleben des Chips auf den Isolierkörper, und Herstellen einer elektrischen Verbindung zwischen den Bondpads des Chips und Leiterfeldern des Substrats mit den Bonddrähten;
f) Gegebenenfalls wiederholen der Schritte bis b) bis e).

Die Reihenfolge der Schritte b) und c) ist nicht zwingend vorgegeben. Ausserdem können einzelne Schritte innerhalb des Verfahrens wiederholt werden.

In Schritt a) wird der Chip mit dem Substrat verbunden. Vorzugsweise wird der Chip auf das Substrat aufgeklebt, z.B. mit einem Werkstoff gemäss Schritt b). Zum Verbinden des Chips mit dem Substrat kann aber auch Kontakt- oder Zweikomponenten- Klebstoff verwendet werden. Das Anlöten des Chips an das Substrat ist ebenfalls denkbar, aber wegen der Gefahr, dass der Chip beschädigt wird, weniger bevorzugt. Ebenfalls ist es möglich, dass der Werkstoff auf den Isolierköper aufgetragen wird, statt wie in Schritt b) beschrieben auf den Chip. Die Bondpads des Chips werden mit Leiterfeldern des Substrats verbunden, vorzusweise durch Ultraschallschweissen oder Thermosonic-Bonden, alternativ auch durch Löten.

Der in Schritt b) aufgebrachte Werkstoff ist vorzugsweise ein heisshärtendes Epoxid-Harz. Dadurch kann das Aushärten des Werkstoffs besonders gut kontrolliert werden. Wenn der Werkstoff ausserdem thixotrop ist, also die Viskosität unter Druckeinwirkung ändert, kann der Isolierkörper gemäss Schritt c) sehr exakt positioniert werden ohne dass der Werkstoff in unerwünschter Weise ausfliesst.

Der Werkstoff kann in Schritt b) an einem einzelnen Punkt auf den Chip aufgetragen werden. Es ist jedoch geeignet, den Werkstoff an mehreren Punkten aufzutragen, da sich dadurch die Stabilität des Isolierkörpers und des darüber gestapelten Chips erhöht.

Nachdem gemäss Schritt c) ein Isolierkörper aufgebracht wurde, ist es vorteilhaft, den Werkstoff zumindest teilweise zu härten. Dies kann z.B. durch Wärmezufuhr geschehen, oder auch durch Lufttrocknung. Dadurch wird die Isolierschicht stabilisiert. Anschliessend wird ein weiterer Chip auf dem Isolierkörper angebracht, vorzugsweise auf die gleiche Art wie der untere Chip. Die Bondpads des zweiten Chips werden mit Leiterfeldern des Substrats verbunden. Im Wesentlichen werden die gleichen Leiterfelder verwendet wie beim ersten Chip. Über die Auswahl der Leiterfelder können den Chips unterschiedliche Bänke zugeordnet werden. Im Betrieb erfolgt die Auswahl der Chips über bankselektive Signale.

Vor oder nach Schritt c) kann Schritt b) auch wiederholt werden. Vorzugsweise wird ein kriechfähiger zweiter Werkstoff zwischen dem Isolierkörper und dem Chip eingebracht, der verbleibende Lücken in der Isolierschicht ausfüllt. Falls ein zweiter Werkstoff eingebracht wird, bevor gemäss Schritt c) ein zweiter Chip angebracht wird, ist es bevorzugt, dass dieser ebenfalls gehärtet wird.

Gemäss einer ersten Ausführungsform werden die höchsten Punkte der Bonddrähte durch den Isolierkörper abgedeckt. Dazu wird ein Chip verwendet, dessen Bonddrähte im Winkel von der Oberfläche des Chips abstehen und in einem Bogen über den Rand des Chips hinaus laufen. Es wird darauf geachtet, dass die Bögen aller Chips möglichst gleich hoch sind. Dadurch ruht der darauf gelegte Isolierkörper auf allen Drähten mit ca. dem gleichen Gewicht.

In einer zweiten Ausführungsform wird ein Chip verwendet, dessen Bonddrähte in einem ersten Abschnitt etwa parallel zur Oberfläche des Chips verlaufend angeordnet sind und im Abstand vom Rand des Chips je einen von der Chip-Oberfläche abstehenden Bogen aufweisen. Dann wird der Isolierkörper derart auf den parallelen Abschnitt der Bonddrähte aufgebracht, dass seine Oberfläche grösseren Abstand zur Oberfläche des darunter liegenden Chips aufweist, als die Bögen der Bonddrähte. Am einfachsten ist das über die Dicke des Isolierkörpers bzw. über die Höhe der Bögen steuerbar. Es ist auch möglich, dass der Isolierkörper über eine dickere Schicht des Werkstoffs auf den Bonddrähten aufliegt.

Es ist auch in der zweiten Ausführungsform vorteilhaft, wenn alle Bonddrähte in etwa die gleiche Bogenhöhe aufweisen. Dadurch wird verhindert, dass ein "Ausreisser" mit zu grosser Bogenhöhe an die Rückseite des oberen Chips stösst.

Vorzugsweise werden bei beiden Ausführungsformen die Bonddrähte auf zwei gegenüberliegende Seiten des Chips geführt.

Aus Platzgründen ist es weiter bevorzugt, dass Chips auf beiden Seiten eines flachen Substrats aufgebracht werden. Dieses Substrat kann beispielsweise eine Speicher-Platte sein.

Bei einem Speichermodul nach der ersten Ausführungsform ist vorteilhaft, wenn der Isolierkörper in einem ersten Schritt mit heisshärtenden ersten Werkstoff, der mindestens auf einem Punkt auf dem Chip aufgebracht wird, über dem Chip fixiert wird und in einem zweiten Schritt durch zufügen von Wärme der Werkstoff ausgehärtet wird. Dadurch fliesst der Werkstoff zugleich und der Isolierkörper wird dadurch bis auf die Bögen der Bonddrähte abgesenkt. Zur Stabilisierung der Platte sind zwei Punkte des Werkstoffs besser geeignet als ein einzelner.

Damit im Endprodukt keine Lufteinschlüsse enthalten sind, werden die Zwischenräume abschliessend mit einem kriechfähigen Werkstoff ausgefüllt.

Die Erfindung wird im Folgenden anhand von Ausführungsbeispielen und Figuren näher erläutert. Es zeigen:
- Fig. 1:: einen Speicherchip auf einem Substrat,
- Fig. 2:: den Speicherchip aus Fig. 1 mit Bonddrähten,
- Fig. 3a - 3c:: das Stapeln zweier Chips übereinander gemäss einer ersten Ausführungsform,
- Fig. 4:: einen Zwischenschritt des Verfahrens gemäss Fig. 3,
- Fig. 5a - 5b:: das Stapeln zweier Chips übereinander gemäss einer zweiten Ausführungsform, und
- Fig. 6:: ein Speichermodul mit Chips auf beiden Seiten eines flächigen Substrats

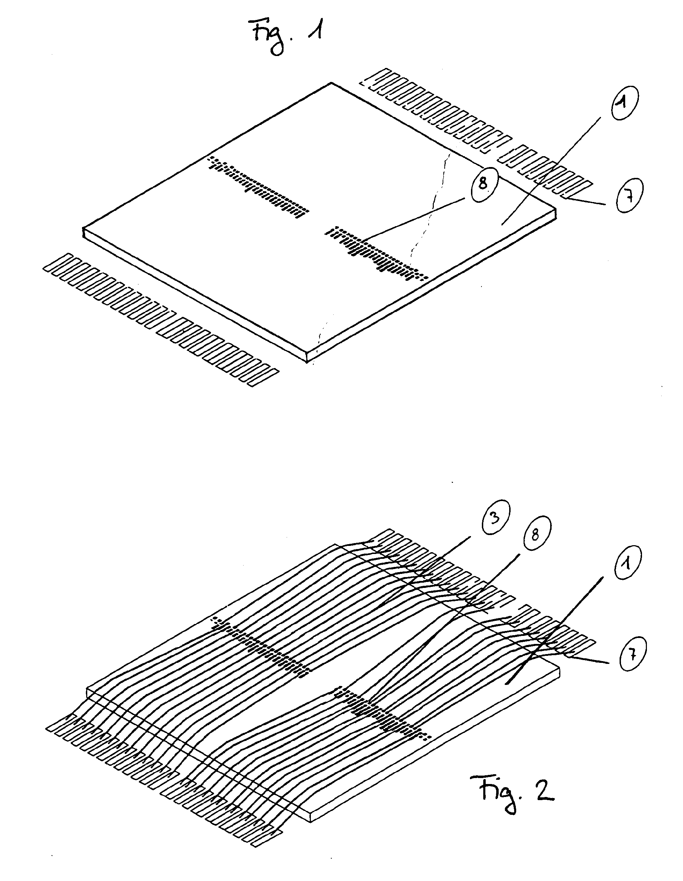

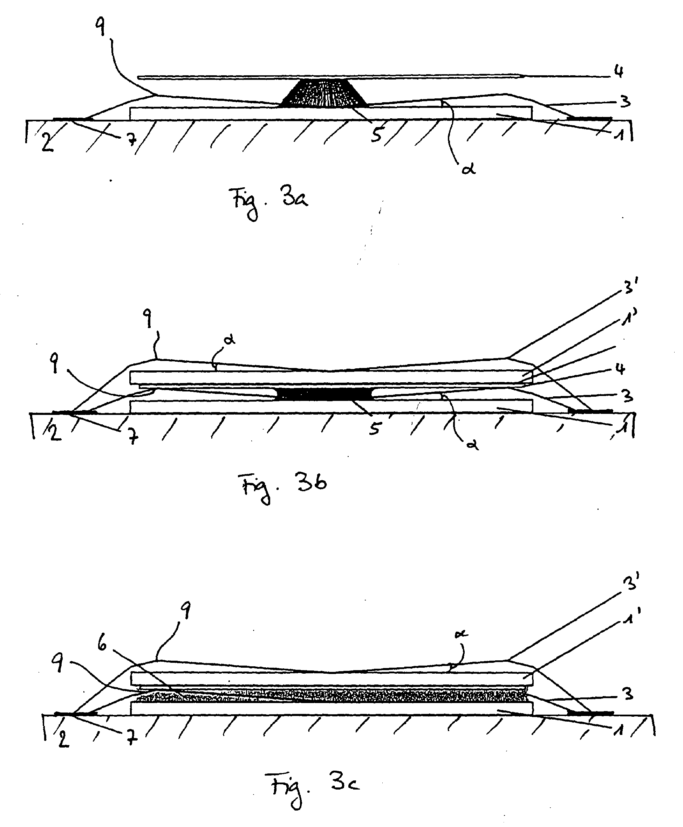

Ein Nacktchip 1 mit zentral angeordneten Bondpads 8 ist gemäss Fig. 1 und 2 auf einem Substrat 2 angeordnet. Die Bondpads 8 werden über Bonddrähte 3 mit den am Substrat 2 angeordneten Leiterfeldern 7 verbunden.

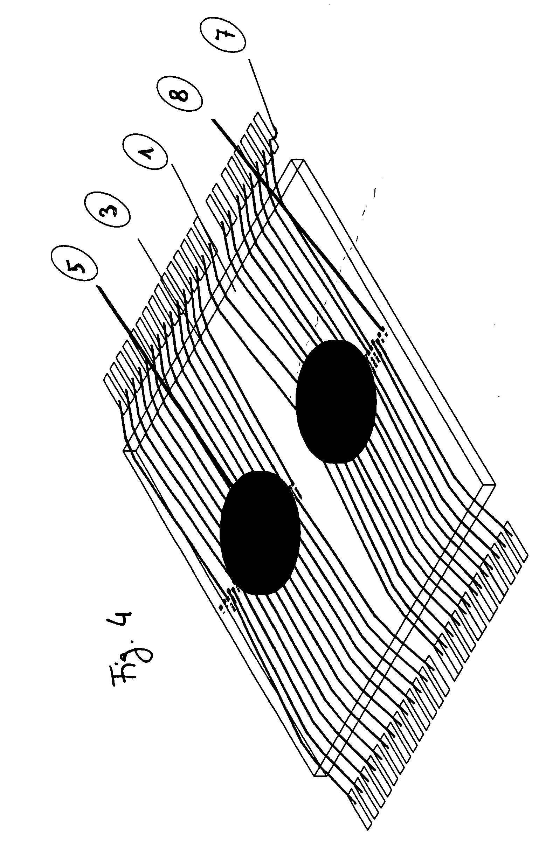

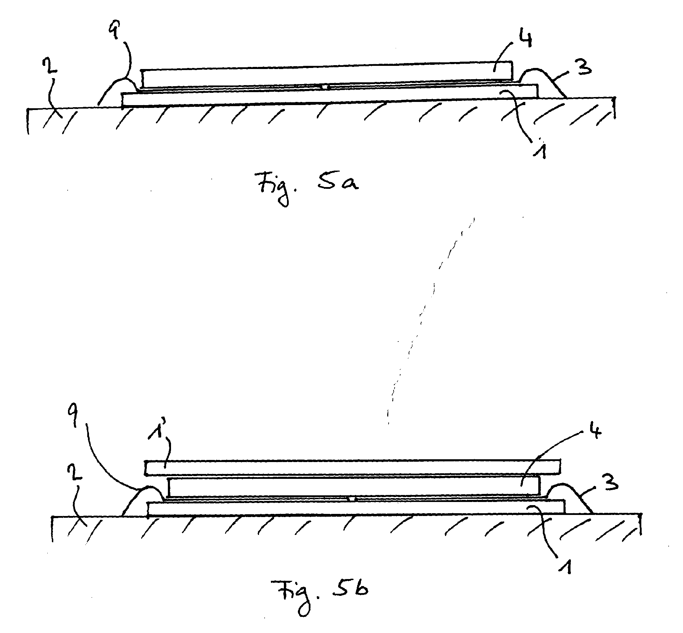

Eine erste Ausführungsform ist in den Fig. 3 und 4 dargestellt. Ein erster Chip 1 ist mit einem nicht dargestellten Werkstoff an das Substrat 2 geklebt (Fig. 3a). Die Bonddrähte 3 werden unter einem Winkel α von der Mitte des Chips 1 weg auf beide Seiten des Chips 1 geführt und verlaufen in einem Bogen 9 über den Rand des Chips 1 hinaus. Der Winkel α beträgt weniger als 5°. Der genaue Winkel α ist durch die Höhe der Bögen 9 bestimmt, wodurch wiederum die Gesamthöhe der Isolierschicht festgelegt wird. Günstig ist, wenn die Höhe der gesamten Isolierschicht 200 µm nicht übersteigt. Durch die Führung der Drähte 3 ist gewährleistet, dass die Bonddrähte 3 die Oberfläche und insbesondere die Kante des unteren Chips nicht berühren. Die Bögen 9 sind ausserdem so gewählt, dass die Bonddrähte 3 nicht an die Kante des unteren Chips stossen.

Auf dem Substrat befinden sich Leiterfelder 7, mit welchen die Bonddrähte 3 verbunden werden. Das Verbinden der Bonddrähte 3 erfolgt durch Ultraschall-Schweissen. Die Bögen 9 der Bonddrähte 3 sind alle gleich hoch, damit der anschliessend darauf gelegte Isolierkörper 4 gleichmässig von den Drähten 3 gestützt wird.

Über den Bondpads 8 werden zwei Tropfen eines hochthixotropen Expoxi-Harzes 5 auf den Chip 1 aufgebracht. Hochthixotrop bedeutet, dass die thixotropen Eigenschaften eines Materials besonders stark ausgeprägt sind. Die Tropfen Epoxid-Harz 5 sind in Fig. 4 in der Draufsicht sichtbar. Ohne äussere Einflüsse bleiben die Tropfen des Epoxid-Harzes 5 in Form und zerfliessen nicht in unkontrollierter oder unerwünschter Weise.

Auf das Epoxid-Harz 5 wird ein Isolierkörper 4 gelegt, der in diesem Fall eine dünne Glasplatte 4 ist. Dadurch, dass das Epoxid-Harz 5 an zwei Punkten aufgebracht wurde, ist der Isolierkörper 4 besser stabilisiert.

Da der Spalt zwischen der Glasplatte 4 und dem Chip 1 nur ca. 200 µm beträgt, sind die Kapillarkräfte im Spalt relativ gross. Das hochthixotrope Epoxid-Harz fliesst durch die Einwirkung dieser Kapillarkräfte. Dieser Effekt wird durch das Zuführen von Wärme noch verstärkt, die Temperatur wird auf 120°C erhöht. Dadurch senkt sich die Platte ab, bis sie auf die Bögen 9 der Bonddrähte 3 stösst (Fig. 3b). In diesem Zustand stützen die Bögen 9 der Drähte 3 die Glasplatte 4, welche somit nicht mehr weiter absinken kann. Es bildet sich eine stabile Position der Platte.

Zum Aushärten wird dem der Epoxid-Harz 5 Wärme zugeführt. Nach einer Härtungszeit von 60 Minuten bei einer Temperatur von 120°C ist das Epoxid 5 in der Position gemäss Fig. 3b fest.

Wenn das Epoxid 5 ausgehärtet ist, wird ein zweiter Chip 1' mit einem nicht dargestellten Klebstoff auf den Isolierkörper 4 angebracht und über Bonddrähte 3' mit Leiterfeldern 7 verbunden. Im Wesentlichen sind dies die gleichen Felder 7, mit denen die Drähte 3 des unteren Chips 1 verbunden wurden. Nur jene Bonddrähte, welche die Betriebsweise, also die zugeordnete Bank, selektieren, werden mit unterschiedlichen Leiterfeldern 7 verbunden.

Das Verfahren kann beliebig lange fortgesetzt werden. Somit ist es möglich, eine gewünschte Anzahl von Chips 1,1' übereinander zu stapeln. Die Länge der Bonddrähte 3' nimmt mit der Höhe der Anordnung zu. Die Zunahme pro Lage entspricht der gesamten Schichtdicke, die im Idealfall 500 µm nicht überschreitet.

Zur Stabilisierung und zum Schutz vor äusseren Einflüssen wird ein zweites Epoxid-Harz 6 in den Zwischenraum zwischen den beiden Chips 1 und 1' und dem Isolierkörper 4 eingebracht. Dieses Epoxid-Harz 6 zeichnet sich durch eine erhöhte Kriechfähigkeit aus, so dass es den gesamten Zwischenraum zuverlässig ausfüllt.

Damit die beiden Epoxid-Harze 5 und 6 die gewünschten Eigenschaften aufweisen, werden ihnen Glaspartikel beigemischt. Die Partikelgrösse im ersten Harz 5 befindet sich im Bereich von 20 - 30 µm, jene im zweiten Harz 6 bei 5 - 10 µm. Die hohe Kriechfähigkeit des zweiten Harzes 6 ist durch die geringe Partikelgrösse und durch die Eigenschaften des Klebstoffs gegeben. Die Partikel bestehen aus Glas, weil Glas einen ähnlichen Wärmeausdehnungskoeffizienten hat wie der Siliziumchip. Dadurch werden Spannungen bei Erwärmung des Moduls reduziert. Selbstverständlich kann auch mit anderen Werkstoffen 5,6 sowie mit anderen Füllstoffpartikeln als Glas eine gute Wirkung erzielt werden, die Erfindung ist nicht auf Epoxid-Harz mit Glaspartikeln eingeschränkt.

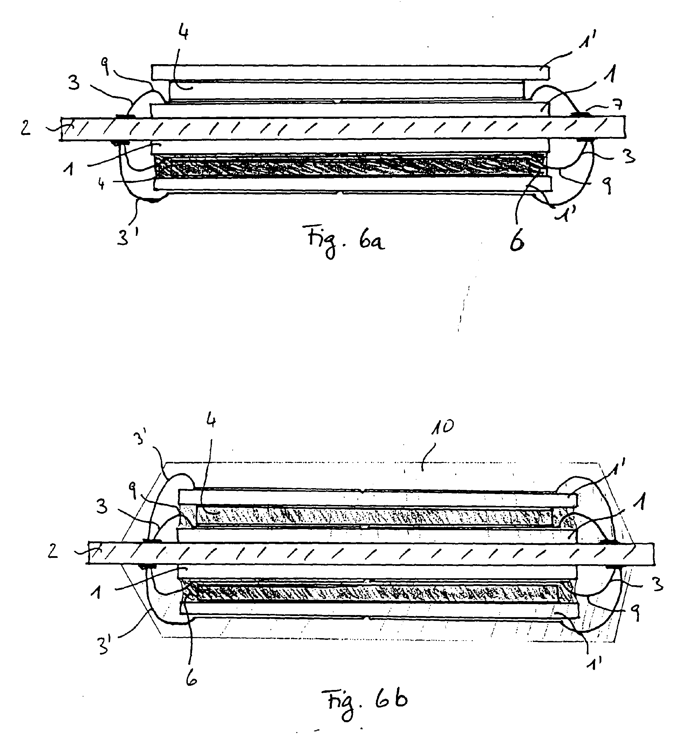

Eine zweite Ausführungsform der Erfindung ist in Fig. 5 dargestellt. Die Bonddrähte 3 werden nicht unter dem Winkel α vom Chip 1 abstehend an den Bondpads 8 angebracht, sondern verlaufen fast über die gesamte Oberfläche des Chips 1 parallel zur Oberfläche. Die Drähte 3 liegen auf der Oberfläche des Chips 1 auf. Da die Vorderseite von Chips 1 mit einer Isolierschicht versehen ist, ist das ohne Nachteile möglich. Die Kante des Chips 1 liegt hingegen frei. Damit der Bonddraht den Chip nicht berührt, wird er in einem relativ scharfen Bogen 9 über die Kante geführt und mit den Leiterfeldern 7 verbunden. Vorteilhaft sind wie bei der ersten Ausführungsform alle Bögen 9 gleich hoch.

Auf den Bereich der Drähte 3, wo sie auf dem Chip 1 aufliegen, wird ein Isolierkörper 4 aufgeklebt. Dies kann wie in diesem Beispiel mit einer dünnen, nicht dargestellten Klebstoffschicht erfolgen. Der Isolierkörper 4 steht in der Höhe über die Bonddrähte 3 hinaus. Somit kann ein zweiter Chip 1' auf den Isolierkörper 4 geklebt werden, ohne dass die Rückseite dieses zweiten Chips 1' die Bonddrähte 3 berührt. Dies ist in Fig. 5b dargestellt.

Zur Verbesserung der Stabilität wird auch in dieser Ausführungsform der verbleibende Freiraum zwischen den beiden Chips 1 und 1' und dem Isolierkörper 4 mit einem Epoxid-Harz 6 mit hoher Kriechfähigkeit ausgefüllt. Dadurch ist gewährleistet, dass die Isolierschicht gleichmässig im Raum zwischen den beiden Chips 1 und 1' verteilt ist.

Analog zur ersten Ausführungsform kann auch in dieser Ausführungsform das Stapeln nach Belieben fortgesetzt werden. Dadurch kann die Nutzfläche auf dem Substrat, hier ein Speicher-Board, erheblich besser genutzt werden.

Um das Speichermodul vor Überhitzung zu bewahren, wird beim Bonden darauf geachtet, dass übereinander liegende Chips nicht der gleichen Bank zugeordnet werden. Weil unterschiedliche Bänke nicht gleichzeitig in Betrieb sind, wird die Erwärmung somit reduziert.

Eine weitere Massnahme zur Sicherung der Funktionalität der Speichermodule ist, dass jede Lage von Chips 1,1' getestet wird, bevor eine weitere Lage darauf angebracht wird. Defekte Chips 1 werden üblicherweise vom Substrat gelöst und durch einen neuen Chip 1 ersetzt. Sie können aber auch neu gebondet werden, falls das den Schaden aufhebt. Durch dieses Vorgehen wird sichergestellt, dass das Speichermodul nicht mit defekten Chips ausgestattet ist.

In Fig. 6 ist ein Speichermodul dargestellt, bei dem die Chips 1, 1' auf beiden Seiten der Speicherplatte 2 angeordnet sind. Die Anordnung entspricht dem Ausführungsbeispiel nach Fig. 5. In Fig. 6a ist der Raum zwischen den Chips 1,1' und dem Isolierkörper 4 bei den in der Darstellung unter der Speicherplatte 2 angebrachten Chips 1,1' mit einem kriechfähigen Epoxid-Harz 6 ausgefüllt worden.

In Fig. 6b ist das fertige Modul dargestellt. Zum Schutz gegen äussere Einflüsse sind die Chips 1,1' mit einem Kunststoff 10 umschlossen worden. Bei einem fertigen Modul können selbstverständlich auch mehrere gestapelte Chips nebeneinander in der Ebene angeordnet werden. Diese Chip-Stapel werden dann vorzugsweise gemeinsam mit einem Kunststoff umhüllt.

## Patentansprüche

1. Speichermodul mit mehreren, vorzugsweise gleich grossen Speicherchips (1,1'), die auf einem Substrat (2) angeordnet sind,
wobei mindestens zwei Chips (1,1') so übereinander gestapelt sind, dass die Rückseite des oberen Chips (1') gegen die Vorderseite des unteren Chips (1) gerichtet ist und übereinander liegende Chips (1,1') durch eine Isolierschicht (4,5,6) getrennt sind,
wobei zentral an den Chips Bondpads (8) angebracht sind, von denen in etwa parallelen Reihen Bonddrähte (3,3') ausgehen,
wobei die Isolierschicht (4,5,6) wenigstens einen festen Isolierkörper (4) und wenigstens einen flüssig einbringbaren, härtenden Werkstoff (5,6) aufweist,
und wobei der Isolierkörper (4) auf den Bonddrähten (3,3') aufliegt.

2. Speichermodul nach Anspruch 1, **dadurch gekennzeichnet, dass** die Bonddrähte (3,3') in einem ersten Winkel (α) von der Oberfläche des Chips (1,1') abstehend angeordnet sind,
dass sie im Abstand vom Rand des Chips je einen Bogen (9) aufweisen und in die Richtung zum Chip-Rand hin verlaufen,
und dass der Isolierkörper (4) auf den Bögen (9) der beiden Reihen von Bonddrähten (3,3') angeordnet ist.

3. Speichermodul nach Anspruch 1, **dadurch gekennzeichnet, dass** die Bonddrähte (3,3') im einem ersten Abschnitt etwa parallel zur Oberfläche des Chips 1,1') verlaufend angeordnet sind,
dass sie im Abstand vom Rand der Chips je einen von der Chip-Oberfläche abstehenden Bogen (9) aufweisen,
und dass der Isolierkörper (4) auf den parallel zur Oberfläche des Chips (1,1') verlaufenden Abschnitten der beiden Reihen von Bonddrähten (3,3') und zwischen den Bögen (9) angeordnet ist.

4. Speichermodul nach einem der Ansprüche 1 bis 3, **dadurch gekennzeichnet, dass** der Wärmeausdehnungskoeffizient der Isolierschicht (4,5,6) nicht mehr als 10% von jenem des Chips (1,1') abweicht.

5. Speichermodul nach einem der Ansprüche 1 bis 4, **dadurch gekennzeichnet, dass** der Isolierkörper (4) wenigstens teilweise aus einem Glas besteht.

6. Speichermodul nach einem der Ansprüche 1 bis 5, **dadurch gekennzeichnet, dass** der Isolierkörper (4) auf beiden Seiten mit einem aushärtenden Werkstoff mit den benachbarten Chips (1,1') verbunden ist.

7. Speichermodul nach einem der Ansprüche 1 bis 6, **dadurch gekennzeichnet, dass** in der Isolierschicht (4,5,6) keine Lufteinschlüsse enthalten sind.

8. Speichermodul nach einem der Ansprüche 1 bis 7, **dadurch gekennzeichnet, dass** der Polymer-Werkstoff (5,6) Füllstoffpartikel aufweist, deren Wärmeausdehnungskoeffizient sich um weniger als 10% von jenem der Chips (1,1') unterscheidet.

9. Speichermodul nach Anspruch 8, **dadurch gekennzeichnet, dass** die Partikel Glas aufweisen oder aus Glas bestehen.

10. Speichermodul nach einem der Ansprüche 1 bis 11, **dadurch gekennzeichnet, dass** der Isolierkörper (4) mit einem ersten Werkstoff (5) mit dem darunterliegenden Chip partiell verbunden ist
und dass der freibleibende Spalt zwischen der Chip-Oberfläche und dem Isolierkörper (4) mit einem zweiten Werkstoff (6) gefüllt ist, wobei die Füllstoff-Teilchen im zweiten Werkstoff (6) kleiner sind als die Füllstoff-Teilchen im ersten Werkstoff (5).

11. Speichermodul nach einem oder mehreren der Ansprüche 1 und 3 bis 10, **dadurch gekennzeichnet, dass** die Oberseite des Isolierkörpers (4) grösseren Abstand von der Oberfläche des darunter angeordneten Chips (1,1') aufweist, als die Bögen (9) der Bonddrähte (3,3').

12. Speichermodul nach einem oder mehreren der vorangegangenen Ansprüche, **dadurch gekennzeichnet, dass** der Werkstoff (5,6) Epoxid-Harz enthält.

13. Speichermodul nach Anspruch 12, **dadurch gekennzeichnet, dass** das Epoxid-Harz ein heisshärtender Epoxid-Klebstoff ist.

14. Speichermodul nach einem oder mehreren der Ansprüche 1 bis 13, **dadurch gekennzeichnet, dass** der Werkstoff (5,6) thixotrope Eigenschaften aufweist.

15. Speichermodul nach einem der vorangehenden Ansprüche, **dadurch gekennzeichnet, dass** übereinander liegende Chips (1,1') unterschiedlichen Bänken zugeordnet sind.

16. Speichermodul nach einem der vorangehenden Ansprüche, **dadurch gekennzeichnet, dass** das Substrat (2) ein Speicher-Board ist und dass die Bonddrähte (3,3') an zwei gegenüberliegenden Seiten des Chips (1,1') mit einem Board verbunden sind.

17. Speichermodul nach einem der vorangehenden Ansprüche, **dadurch gekennzeichnet, dass** die Chips (1,1') auf beiden Seiten eines flachen Substrats (2) angeordnet sind.

18. Verfahren zum Herstellen eines Speichermoduls aus wenigstens zwei übereinander gestapelten Chips (1,1') auf einem Substrat (2) unter Verwendung von Chips (1,1') mit Bonddrähten (3,3'), die in etwa parallelen Reihen am Mittelabschnitt der Oberfläche des Chips (1,1') angeordnet sind, umfassend die Schritte:
a) Verbinden eines ersten Chips (1) mit einem Substrat (2), insbesondere Kleben des Chips (1) an das Substrat (2), und Herstellen einer elektrischen Verbindung zwischen den Bondpads (8) des Chips (1) und Leiterfeldern (7) des Substrats (2) mit den Bonddrähten (3);
b) Auftragen eines fliessfähigen, vorzugsweise thixotropen aushärtenden Werkstoffs (5,6) an mindestens einen Punkt auf dem Chip;
c) Aufbringen eines Isolierkörpers (4) auf den Werkstoff (4,5) zum wenigstens teilweisen Abdecken der Bonddrähte (3) ;
d) Zumindest teilweises Härten des Klebstoffs
e) Verbinden eines weiteren Chips (1') mit dem Isolierkörper (4), insbesondere Kleben des Chips (1') auf den Isolierkörper (4), und Herstellen einer elektrischen Verbindung zwischen den Bondpads (8) des Chips (1') und Leiterfeldern (7) des Substrats (2) mit den Bonddrähten (3');
f) Gegebenenfalls wiederholen der Schritte bis b) bis e).

19. Verfahren nach Anspruch 18, **dadurch gekennzeichnet, dass** durch den Isolierkörper (4) die höchsten Punkte der Bonddrähte abgedeckt werden.

20. Verfahren nach Anspruch 18 unter Verwendung eines Chips dessen Bonddrähte in einem ersten Abschnitt etwa parallel zur Oberfläche des Chips (1,1') verlaufend angeordnet sind und im Abstand vom Rand des Chips (1,1') je einen,von der Chip-Oberfläche abstehenden Bogen (9) aufweisen,
**dadurch gekennzeichnet, dass** der Isolierkörper (4) derart auf den parallelen Abschnitt der Bonddrähte (3,3') aufgebracht wird, dass seine Oberfläche grösseren Abstand zur Oberfläche des darunter liegenden Chips (1,1') aufweist, als die Bögen (9) der Bonddrähte (3,3').

21. Verfahren nach einem der Ansprüche 18 bis 20, **dadurch gekennzeichnet, dass** die Bonddrähte (3,3') auf zwei gegenüberliegende Seiten des Chips (1,1') geführt werden.

22. Verfahren nach einem der Ansprüche 18 bis 21, **dadurch gekennzeichnet, dass** Chips (1,1') auf beiden Seiten eines flachen Substrats (2) aufgebracht werden.

23. Verfahren nach Anspruch 19, **dadurch gekennzeichnet, dass** der Isolierkörper (4) in einem ersten Schritt mit einem heisshärtenden ersten Werkstoff (5), der mindestens auf einem Punkt auf dem Chip (1,1') aufgebracht wird, über dem Chip (1,1') fixiert wird und in einem zweiten Schritt durch zufügen von Wärme der Werkstoff (5) ausgehärtet wird, wobei durch das Erwärmen zugleich die Visokosität des Werkstoffs (5) sinkt und der Isolierkörper (1,1') **dadurch** bis auf die Bögen (9) der Bonddrähte (3,3') abgesenkt wird.
